Europäisches Patentamt

European Patent Office

Office européen des brevets

(19)

(11) **EP 1 519 285 A1**

(12) **DEMANDE DE BREVET EUROPEEN**

(43) Date de publication:
**30.03.2005 Bulletin 2005/13**

(51) Int Cl.$^7$: **G06F 17/50**

(21) Numéro de dépôt: **04292144.5**

(22) Date de dépôt: **01.09.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **26.09.2003 FR 0311281**

(71) Demandeur: **ALCATEL**
**75008 Paris (FR)**

(72) Inventeur: **Guillaume, Sebastien**
**91300 Massy (FR)**

(74) Mandataire: **Fournier, Michel Robert Marie et al**
**COMPAGNIE FINANCIERE ALCATEL**
**Département Propriété Industrielle**
**54, rue La Boétie**
**75008 Paris (FR)**

(54) **Systeme de connexion de type bus d'ordinateur, notamment pour fond de panier**

(57) L'invention concerne les systèmes de connexion de type bus, en particulier ceux qui permettent de câbler les fonds de panier des systèmes électroniques, quand ces bus comprennent des connecteurs répartis de manière irrégulière

Elle consiste à sélectionner des segments ($D_1, D_2$) sur lesquels les intervalles (d1,d2) entre les connecteurs sont sensiblement constants. On modifie alors la structure de tous les segments saufs un, pour faire coïncider l'impédance effective de ces segments modifiés avec celle du segment non modifié.

Elle permet d'obtenir un bus entièrement adapté d'un bout à l'autre, pouvant fonctionner à une fréquence très élevée avec une légère réduction de sa constante de propagation.

FIG_2

**Description**

La présente invention se rapporte aux systèmes de connexion de type bus, c'est-à-dire aux systèmes qui comportent au moins une ligne bifilaire sur laquelle sont disposés des connecteurs qui permettent de raccorder des dispositifs électroniques à des emplacements indifférenciés. Les informations qui circulent sur cette ligne sont reçues ou émises sur le bus à l'aide d'un système de codage, généralement temporel, qui permet de déterminer quel est le dispositif concerné par ces informations. Le plus souvent le bus comprend un ensemble de lignes qui permettent de transmettre les informations en mode parallèle. Ce système est universellement utilisé dans les ordinateurs du type PC pour connecter les cartes d'extension. Il est aussi très utilisé en électronique professionnelle pour câbler les fonds des paniers dans lesquels on insère des cartes électroniques diverses permettant de réaliser le matériel souhaité.

Le plus souvent, les connecteurs sont fixés au fond du panier à des intervalles équidistants et ils sont réunis par des conducteurs électriques dont les longueurs d'un connecteur au suivant sont identiques. L'ensemble forme donc une ligne, ou une multiplicité de lignes, de transmission à impédance caractéristique constante qui permet de transmettre des signaux, notamment numériques, à très haute fréquence, avec une déformation minime.

Dans certains cas particuliers, il n'est toutefois pas possible de maintenir cette équidistance, ce qui entraîne une modification de l'impédance caractéristique le long de la ligne, en fonction de l'écartement entre les connecteurs. Ceci provoque une variation du temps de propagation le long de la ligne, ainsi que des réflexions localisées, qui entraînent des déformations des signaux transmis. Ces phénomènes limitent la fréquence à laquelle les signaux peuvent être transmis.

Pour surmonter ces limitations, l'invention propose un système de connexion de type bus, notamment pour fond de panier, du type comprenant au moins une ligne de transmission le long de laquelle sont branchés des connecteurs destinés à recevoir des cartes électroniques, pour chaque ligne ce bus étant composé d'au moins deux segments, chaque segment comprenant un ensemble de connecteurs disposés à des intervalles sensiblement constants le long de chaque segment, ces intervalles étant toutefois sensiblement distincts d'un segment à l'autre, lesdites cartes électroniques modifiant l'impédance du segment sur lequel elles sont connectées pour donner une impédance "effective", caractérisé en ce que la structure de la ligne de transmission de l'un des segments est modifiée par rapport à celle de l'autre segment pour faire coïncider son impédance effective avec celle de l'autre segment.

L'avantage de cette solution est qu'elle n'implique aucun supplément de coût de fabrication autre que de prévoir des dimensionnements appropriés des lignes le long de ces lignes.

Selon une autre caractéristique, le système comprend un ensemble de segments présentant respectivement des intervalles sensiblement distincts entre les connecteurs respectifs de ces segments, caractérisé en ce que la structure de ligne de tous les segments, sauf un, est modifiée par rapport à un segment donné, pour faire coïncider leurs impédances effectives avec celle du segment non modifié.

Selon une autre caractéristique, le segment non modifié est celui pour lequel l'impédance effective est la plus faible.

Selon une autre caractéristique, le segment non modifié est celui pour lequel la distance entre les connecteurs est la plus faible.

Selon une autre caractéristique, chaque ligne étant sous la forme d'une piste d'épaisseur donnée, la structure d'une ligne est modifiée en modifiant sa largeur.

Selon une autre caractéristique, le système comprend un ensemble de lignes de transmission modifiées de la même manière.

D'autres particularités et avantages de l'invention apparaîtront clairement dans la description suivante, faite en regard des figures annexées qui représentent :

- la figure 1, un bus comportant deux parties désadaptées entre elles ;
- la figure 2, le bus de la figure 1, corrigé selon l'invention ;
- la figure 3, un graphique des signaux pris sur le bus de la figure 1 ; et
- la figure 4, un graphique des signaux pris sur le bus de la figure 2.

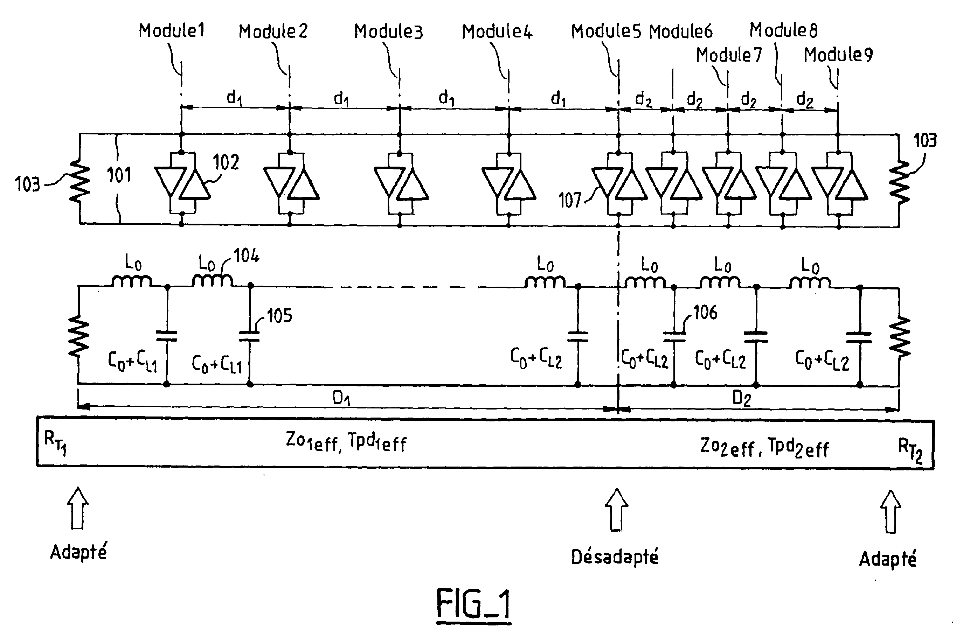

On a représenté schématiquement sur la figure 1 un exemple particulier de réalisation correspondant à un bus de fond de panier d'une longueur totale $D_1 + D_2 = 75$ cm. Pour simplifier l'exposé, on a représenté une ligne relative à un seul signal, étant entendu qu'un bus comportera généralement un nombre plus important de lignes. L'invention s'appliquera alors de la même manière à chaque ligne faisant partie du bus.

Dans le but d'utiliser ce bus à des fréquences de l'ordre de 40 MHz, la technique utilisée pour réaliser ce bus, par exemple au moyen de pistes conductrices du type "strip-line", permet de l'obtenir sous la forme d'une ligne de transmission à constantes réparties dont l'impédance caractéristique est par exemple donnée par :

$L_0 = 4,73$ nH/cm ; $C_0 = 1,06$ pF/cm ; $Z_0 = 67 \ \Omega$ ; $T_{pd} = 70,7$ ps/cm

Dans la représentation physique du haut de la figure, on voit un ensemble d'amplificateurs d'entrée/sortie 102, dits "buffers", correspondant aux cartes qui sont connectées à la ligne 101, par des connecteurs non représentés. Cette ligne est bouclée à ses extrémités par des résistances adaptées 103.

Pour des besoins particuliers à cet exemple de réalisation, les 4 premiers amplificateurs d'entrée/sortie sont fixés à des intervalles $d_1$ sur un premier segment de longueur $D_1$ et les 5 derniers amplificateurs sont fixés à des intervalles $d_2$ sur un deuxième segment de longueur $D_2$. Dans cet exemple, $d_1 = 10$ cm, $D_1 = 50$cm, $d_2 = 5$ cm et $D_2 = 25$ cm.

Chacun de ces amplificateurs ramène sur la ligne, à l'endroit où il est fixé, une capacité supplémentaire $C_L$, égale dans cet exemple à 12 pF.

Comme représenté sur le schéma équivalent du centre de la figure 1, la ligne se comporte comme une ligne à constantes réparties avec une inductance série représentée par des inductances 104 et une capacitance parallèle. Sur toute la longueur de la ligne la valeur de l'inductance est égale à $L_0$. Sur la longueur $D_1$ la valeur de la capacitance de base du bus est modifiée par les capacités des amplificateurs pour avoir une valeur représentée sur la figure par des condensateurs 105 dont la valeur est égale à $C_0 + C_{L1}$, et sur la longueur $D_2$ par des condensateurs 106 dont la valeur est égale à $C_0 + C_{L2}$. Les valeurs de $C_{L1}$ et de $C_{L2}$ sont obtenues en répartissant sur les longueurs correspondantes la valeur de la capacité supplémentaire $C_L$. Donc $C_{L1} = C_L/d_1$ et $C_{L2} = C_L/d_2$.

Ceci entraîne que l'impédance effective n'est pas la même tout le long du bus. Elle sera égale à $Z_{01eff}$ sur la longueur $D_1$ jusqu'au premier 107 de la deuxième série des modules et à $Z_{02eff}$ sur la longueur $D_2$ jusqu'à l'extrémité de la ligne. Ces valeurs sont données par les formules suivantes :

$$Z_{01\,eff} = Z_0 \sqrt{\frac{1}{1+\dfrac{C_L}{d_1.C_0}}} \qquad\qquad Z_{02\,eff} = Z_0 \sqrt{\frac{1}{1+\dfrac{C_L}{d_2.C_0}}}$$

Le délai de propagation effectif sera affecté de la même manière et l'on aura :

$$T_{pd\,1eff} = T_{pd} \sqrt{1+\frac{C_L}{d_1.C_0}} \qquad\qquad T_{pd\,2eff} = T_{pd} \sqrt{1+\frac{C_L}{d_2.C_0}}$$

Il en résulte que, comme représenté de manière symbolique dans le bas de la figure 1, le bus présentera une rupture d'impédance au niveau de l'emplacement du module 5, correspondant à la transition entre les longueurs $D_1$ et $D_2$. Par contre il peut-être adapté à chaque bout en plaçant des résistances de terminaison $R_{T1}$ et $R_{T2}$ correspondant aux impédances caractéristiques en ces endroits.

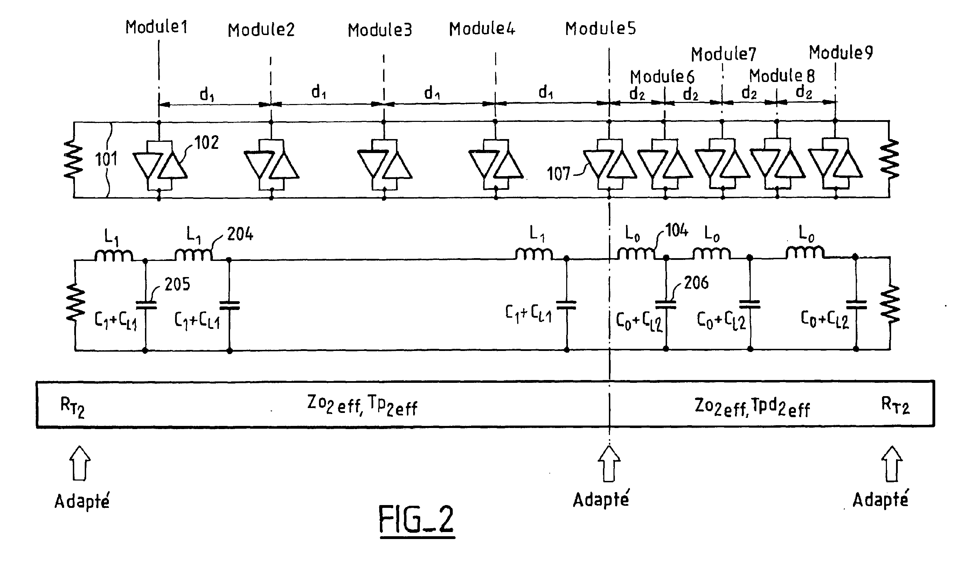

L'invention propose alors de modifier la structure de la ligne de transmission du bus sur la longueur D1 de manière à ce que sur cette longueur, en tenant compte de l'influence des amplificateurs d'entrée/sortie 102, l'impédance caractéristique effective sur cette longueur soit égale à l'impédance caractéristique effective sur la longueur $D_2$. Dans ces conditions, comme représenté sur la figure 2, qui correspond aux mêmes conventions que la figure 1, le bus, avec ses amplificateurs, est adapté de bout en bout. Il est préférable, pour des raisons techniques, de diminuer l'impédance la plus grande que d'augmenter l'impédance la plus petite, c'est-à-dire celle du segment où l'intervalle est le plus petit.

La modification de la structure de la ligne réalisation du bus peut se faire simplement en modifiant sa géométrie, typiquement les dimensions de la ou des piste(s) conductrice(s) généralement utilisée(s) pour réaliser une ligne de bus. Souvent, l'épaisseur et le placement de chaque piste est imposé. Dans ce cas, la structure d'une ligne est modifiée en modifiant sa largeur seulement.

Compte tenu des possibilités physiques, on sera ainsi le plus souvent amené à modifier à la fois la valeur de l'inductance répartie 204 sur cette longueur $D_1$, qui prendra alors une autre valeur, égale par exemple à $L_1$, et la valeur de la capacitance répartie, qui prendra alors une valeur égale par exemple à $C_1$. L'impédance caractéristique intrinsèque, c'est-à-dire en dehors de l'action des amplificateurs 102, de cette partie du bus, sera alors égale à $Z_1$. Dans ces conditions, on aura :

$$Z_{01eff} = Z_{02eff} = Z_1 \sqrt{\dfrac{1}{1 + \dfrac{C_L}{d_1.C_1}}}$$

On sera donc amené à jouer sur les deux paramètres $Z_1$ et $C_1$, qui ne sont pas totalement indépendants puisque $Z_1$ dépend de $C_1$. Dans la pratique, on pourra prendre par exemple une méthode d'itération consistant à fixer une première valeur raisonnable pour $C_1$, ce qui permet de calculer alors une première valeur de $Z_1$. Cette première valeur de $Z_1$ permet de dimensionner le bus, par exemple en utilisant un simulateur commercial du type HP_ADS. Si ce dimensionnement ne convient pas, on le modifiera dans un sens physiquement acceptable, ce qui donnera des deuxièmes valeurs de $Z_1$ et de $C_1$. On calculera ensuite l'impédance $Z_{01eff}$ correspondante, qui sera certainement différente de $Z_{02eff}$. Selon le sens de l'écart, on recommencera ce processus en le faisant converger pour obtenir l'égalité $Z_{01eff} = Z_{02eff}$. On aura les capacitances effectives 205 $C_1 + C_{L1}$ et 206 $C_0 + C_{L2}$

Cette méthode, qui a été décrite dans le cadre de deux intervalles distincts, peut-être généralisée à un nombre quelconque d'intervalles.

Pour cela on commencera par repérer l'impédance effective minimale en calculant ces impédances pour toutes les sections définies chacune par un intervalle identique entre leurs amplificateurs d'entrée/sortie, c'est-à-dire celle où l'intervalle est le plus faible.

On utilisera ensuite le procédé décrit ci-dessus pour chacune de ces sections repérées par l'indice x, pour obtenir l'égalité suivante :

$$Z_{0\,min\,eff} = Z_0 \sqrt{\dfrac{1}{1 + \dfrac{C_L}{d_{min}.C_0}}} = Z_{0xeff} = Z_x \sqrt{\dfrac{1}{1 + \dfrac{C_L}{d_x.C_x}}}$$

On calculera alors, par des procédés connus en eux-mêmes, les résistances terminales d'adaptation du bus. Dans le cas particulier de la figure 2, seule la résistance d'entrée 203 change, puisque seule l'impédance de la première section a changé.

On terminera en vérifiant, de préférence par simulation avec le simulateur décrit plus haut, le bon comportement du bus avec des signaux numériques. S'il n'est pas suffisamment bon, on recommencera les opérations pour obtenir un autre couple de valeurs $C_1, L_1$.

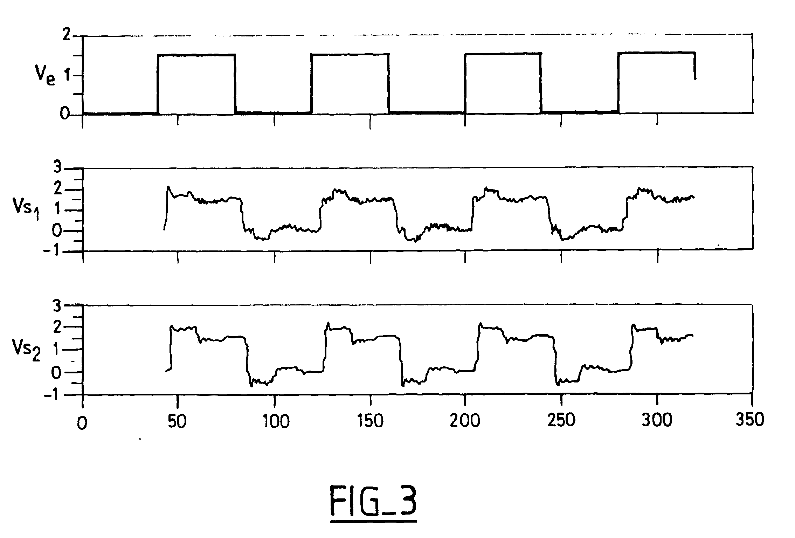

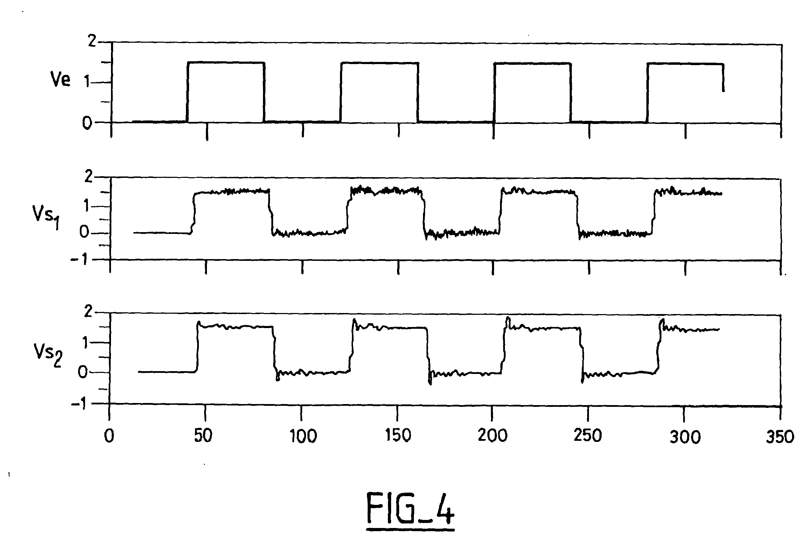

On a représenté sur la figure 3 le signal d'entrée rectangulaire $V_e$ et des signaux $V_{s1}$ et $V_{s2}$ pris respectivement aux niveaux du cinquième module et de la sortie du bus, dans le cas du bus désadapté représenté sur la figure 1, et sur la figure 4 ces mêmes signaux dans le cas du bus adapté représenté sur la figure 2. Les échelles sont en Volts et en ns. On constate que l'amélioration est particulièrement significative.

C'est amélioration se fait toutefois au détriment du temps de transit global dans le bus, puisque la vitesse de propagation est ramenée pour toutes les parties des bus à celle de la section où cette vitesse de propagation est la plus faible.

La description précédente a montré le cas où les intervalles entre connecteurs de chaque segment était constants et égaux à des valeurs précises $d_1$ ou $d_2$. En pratique, cette situation idéale n'est pas toujours réalisable, mais l'invention reste applicable si les intervalles sont sensiblement constants, c'est-à-dire restent voisins d'une valeur moyenne caractéristique de chaque segment considéré.

**Revendications**

**1.** Système de connexion de type bus, notamment pour fond de panier, du type comprenant au moins une ligne de transmission (101) le long de laquelle sont branchés des connecteurs destinés à recevoir des cartes électroniques (102), pour chaque ligne ce bus étant composé d'au moins deux segments ($D_1$, $D_2$), chaque segment comprenant

un ensemble de connecteurs disposés à des intervalles sensiblement constants ($d_1$, $d_2$) le long de chaque segment, ces intervalles étant toutefois sensiblement distincts d'un segment à l'autre, lesdites cartes électroniques modifiant l'impédance du segment sur lequel elles sont connectées pour donner une impédance "effective" ($Z_{02eff}$), **caractérisé en ce que** la structure de la ligne de transmission de l'un des segments est modifiée par rapport à celle de l'autre segment pour faire coïncider son impédance effective ($Z_{01eff}$) avec celle de l'autre segment.

2. Système selon la revendication 1, **caractérisé en ce qu'**il comprend un ensemble de segments ($D_1$, $D_2$) présentant respectivement des intervalles sensiblement distincts entre les connecteurs respectifs de ces segments, **caractérisé en ce que** la structure de ligne de tous les segments, sauf un, est modifiée par rapport à un segment donné, pour faire coïncider leurs impédances effectives avec celle du segment non modifié.

3. Système selon la revendication 2, **caractérisé en ce que** le segment non modifié est celui pour lequel l'impédance effective ($Z_{0\ min\ eff}$) est la plus faible.

4. Système selon la revendication 2, **caractérisé en ce que** le segment non modifié est celui pour lequel la distance ($d_2$) entre les connecteurs est la plus faible.

5. Système selon l'une quelconque des revendications 1 à 4, **caractérisé en ce que** chaque ligne étant sous la forme d'une piste conductrice d'épaisseur donnée, la structure d'une ligne est modifiée en modifiant sa largeur.

6. Système selon l'une quelconque des revendications 1 à 5, **caractérisé en ce qu'**il comprend un ensemble de lignes de transmission (101) modifiées de la même manière.

EP 1 519 285 A1

Module 1   Module 2   Module 3   Module 4   Module 5 Module 6   Module 8

Module 7   Module 9

$d_1$   $d_1$   $d_1$   $d_1$   $d_2$   $d_2$   $d_2$   $d_2$

103   101   102   107   103

$L_0$   $L_0$   104   $L_0$   $L_0$   $L_0$   $L_0$

105   106

$C_0 + C_{L1}$   $C_0 + C_{L1}$   $C_0 + C_{L2}$   $C_0 + C_{L2}$   $C_0 + C_{L2}$   $C_0 + C_{L2}$

$D_1$   $D_2$

$R_{T_1}$   $Z_{o1eff}, Tpd_{1eff}$   $Z_{o2eff}, Tpd_{2eff}$   $R_{T_2}$

Adapté   Désadapté   Adapté

FIG_1

FIG_2

EP 1 519 285 A1

FIG_3

EP 1 519 285 A1

FIG_4

**Office européen des brevets**

**RAPPORT DE RECHERCHE EUROPEENNE**

Numéro de la demande

EP 04 29 2144

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | EP 0 665 647 A (IBM) 2 août 1995 (1995-08-02) | 1,2 | G06F17/50 |
| A | * colonne 2, ligne 25 - ligne 57 * * colonne 7, ligne 15 - colonne 8, ligne 3 * | 3-6 | |
| Y | US 6 484 293 B1 (STARR JONATHAN E) 19 novembre 2002 (2002-11-19) | 1,2 | |
| A | * colonne 1, ligne 24 - ligne 55 * * colonne 2, ligne 54 - colonne 3, ligne 17 * | 3-6 | |
| A | US 6 466 008 B1 (FUNG PATRICK YING-CHEUNG ET AL) 15 octobre 2002 (2002-10-15) * colonne 1, ligne 24 - ligne 31 * * colonne 1, ligne 63 - colonne 2, ligne 9 * | 1-6 | |

DOMAINES TECHNIQUES RECHERCHES (Int.Cl.7)

G06F

Le présent rapport a été établi pour toutes les revendications

| Lieu de la recherche | Date d'achèvement de la recherche | Examinateur |
|---|---|---|
| La Haye | 3 novembre 2004 | Nguyen Xuan Hiep, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**
EP 04 29 2144

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-11-2004

| Document brevet cité au rapport de recherche | | Date de publication | Membre(s) de la famille de brevet(s) | | Date de publication |
|---|---|---|---|---|---|
| EP 0665647 | A | 02-08-1995 | US | 5544047 A | 06-08-1996 |
| | | | AT | 170347 T | 15-09-1998 |
| | | | BR | 9405191 A | 08-08-1995 |
| | | | CA | 2118148 A1 | 30-06-1995 |
| | | | DE | 69412781 D1 | 01-10-1998 |
| | | | DE | 69412781 T2 | 15-04-1999 |
| | | | EP | 0665647 A1 | 02-08-1995 |
| | | | ES | 2120579 T3 | 01-11-1998 |
| | | | JP | 2845424 B2 | 13-01-1999 |
| | | | JP | 7212406 A | 11-08-1995 |
| | | | US | 5638287 A | 10-06-1997 |
| | | | US | 5757654 A | 26-05-1998 |
| US 6484293 | B1 | 19-11-2002 | AUCUN | | |
| US 6466008 | B1 | 15-10-2002 | AUCUN | | |

EPO FORM P0460

Pour tout renseignement concernant cette annexe : voir Journal Officiel de l'Office européen des brevets, No.12/82